# EUROPEAN PATENT APPLICATION

(11) **EP 4 672 951 A1**
(43) Date of publication of application: **31.12.2025**
(21) Application number: 24185500.6
(22) Date of filing: 28.06.2024
(51) Int. Cl.: H10N 60/01, H10N 60/80

(54) **METHOD FOR PRODUCING A SUPERCONDUCTIVE JOINT WITH HERMETIC SEALING**

(71) Applicant: Bruker Switzerland AG, 8117 Fällanden (CH)
(72) Inventor: NARDELLI, Davide, 8604 Volketswil (CH); ALESSANDRINI, Matteo, 8152 Opfikon (CH)
(74) Representative: Kohler Schmid Möbus Patentanwälte

(57) **Abstract**

A method for producing a superconductive joint from a number of electrical conductors (10), each electrical conductor (10) having one or a multitude of filaments (3) comprising either a superconductor precursor material or a mixture of superconductor material and precursors of superconductor material, encapsulated in a metallic structure (4), the method comprising:
• a joining step, for joining end sections (1) of the electrical conductors (10), the joining step comprising:
∘ generating two complementary cut surfaces (2) on the end sections (1) thereby exposing cross sections of the filaments (3);
∘ forming an interface area (5) of the cut surfaces (2) by aligning the two end sections (1) in a connection zone (6) such that the cut surfaces (2) of the end sections (1) face each other and the exposed filament cross sections abut each other;
∘ pressing the aligned complementary cut surfaces (2) together;

• a synthesis step, in which superconductor precursor material is converted into superconductor material by annealing,
is characterized in that the method further comprises
• a hermetic sealing step in which the metallic structure of the conductors (10) is hermetically sealed against gases, vapors, or liquids at room temperature.

The inventive method offers increased performances, in particular homogeneous performance over the entire length of the wire, and prevents degradation of the superconducting properties during the synthesis reaction.

## Description

### Background of the invention

The invention concerns a method for producing a superconductive joint from a number of electrical conductors, each electrical conductor having one or a multitude of filaments comprising either a superconductor precursor material or a mixture of superconductor material and precursors of superconductor material, encapsulated in a metallic structure, the method comprising a joining step, for joining end sections of the electrical conductors, the joining step comprising: generating two complementary cut surfaces on the end sections thereby exposing cross sections of the filaments, forming an interface area of the cut surfaces by aligning the two end sections in a connection zone such that the cut surfaces of the end sections face each other and the exposed filament cross sections abut each other, and pressing the aligned complementary cut surfaces together, and a synthesis step, in which superconductor precursor material is converted into superconductor material by annealing.

Superconductor materials are often used in wires for superconductive magnets.

In the production of superconductors, precursor materials are turned into superconductor materials by annealing (synthesis process). In order to connect different sections of a superconducting magnet, conductors have to be connected in a superconducting way ("superconducting joint"). The joining process can be performed prior to the synthesis process (i.e. conductors comprising superconductor precursor material are joined) or after the synthesis process (i.e. conductors comprising superconductor material are joined).

Superconductor materials that are used for superconductive magnets are for example Bismuth strontium calcium copper oxide (BSCCO), in particular Bi2212 and Bi2223, Niobium-tin (Nb3Sn), and Niobium-titanium (NbTi).

US 5244876 A discloses a method for producing a superconductive joint, where the joint is performed by directly splicing conductors / bars of superconducting materials under a direct flame in 1 bar atmosphere of oxygen / acetylene flame. Yet, the process is difficult to control, hence it reasonably leaves openings.

US 5949131 A proposes to expose the inner filaments of the two endings and put them face to face and press to put in contact the filaments. At the end, the annealing process is performed.

US 5051397 A proposes to use an intermediate brazing material, heated at relatively low temperature, to join the superconducting conductors, resulting in a low resistance joint. This process results in a low resistivity (but not a superconducting) joint, since the addition of the solder metals to the wires before reaction at high temperature leads to unwanted reaction which destroy the superconducting phase.

US 5111574 A discloses a method to superconductively join Nb3Sn conductors by exposing the inner precursor Nb and Sn filaments of the two wire endings, seal them in a copper enriched chamber and then heat such a joint structure to react the Sn and Nb to form Nb3Sn. The presence of an external structure increases the dimension and the complication of the jointing process, and, in certain cases (like for Bi2212) might not permit the oxygenation of the inner superconducting phase.

EP 0545608 A2 discloses a method for joining oxide superconducting tapes having a core of precursor powder in a silver sheath, consisting in removing a part of sheath, overlapping the cores and the sheaths, pressing to compact the cores and bond the sheaths to seal the compacted cores and then heated to form the oxide superconductor.

EP 0556837 A2 discloses a method for producing a superconductive joint between oxide superconducting multifilamentary wires, consisting in exposing the filaments, superimpose them, apply a plastic deformation perpendicular to the large surface and apply an annealing process to restore the superconducting properties of the joint.

US 9966167 B1 discloses a method for producing a superconductive joint between Bi2212 wires through an intermediate Bi2212 superconducting material contained and sealed in a cup. The technique needs an intermediate element to join the wires during the reaction of Bi2212 in the wires (not direct joint), but if the intermediate joining element is the bi2212 powder or precursor of it, it releases gas which shall enter the wires endings degrading the properties, and if it is another more inert material, the gas will, instead, exit from the wires endings together with the melted Bi2212 phase, degrading the wire performances.

The known methods suffer from the following drawbacks:
The final annealing to synthesize Bi2212 precursor or Bi2212 precursor phase to Bi2212 continuous superconductor material must be carried out in a furnace at a temperature around 900°C and an Ar/O2 pressure typically of over 25 bar. This is required to homogenize and improve the performances along the wire, and to avoid apertures, which would be created by the internal gas release. But, when realizing a superconducting joint between two end sections of the wire (for example, in case of different sections in a magnet), the precursor material has to be exposed prior to the Bi2212 synthesis reaction by opening the endings of the wire to put the precursor material of the two end sections in contact with each other. As a result, the pressurized gas penetrates the inside of the wire, which reduces the performance of the wire after the thermal reaction and thus severely limits the performance of the connection itself.

In the production of Nb3Sn superconductors using internal tin technology, the exposure of the precursor material required for joining the end sections causes the tin in the Nb3Sn wire (prior to its reaction) to escape from the connection zone.

This changes the stoichiometry of the components and thus reduces or completely destroys the performance. In case the synthesis is not performed in vacuum, the external gas can react with the components of the wire (tin, niobium, copper), which hinders the formation of Nb3Sn.

The same effects can happen, for example, also for MgB2 wires and its components.

Another complication with the joining technologies occurs when the joints are immersed in liquid Helium (which, nowadays, is the predominant case). In fact, if the wire is porous (as is the case for all wires produced with powder-in-tube technology, such as Bi2212, MgB2 and some Nb3Sn wires), the Helium penetrates through the joints into the porosities of the wires. In the event of quenching or thermal cycles, the transition of the liquid Helium into the gas state can degrade the wires as a high gas pressure is created inside the wire, which threatens to stretch the wire and the joint.

Even considering the case of cryogen-free cooled system (i.e.: no helium), if the joints are permeable or open to the gases / vapor passage, there can be a reaction with the superconducting phase and constituents, degrading the superconducting properties.

### Object of the invention

It is an object of the invention to provide a method for producing a superconductive joint with offers increased performances, in particular homogeneous performance over the entire length of the wire, and prevents degradation of the superconducting properties during the synthesis reaction.

### Description of the invention

This object is achieved by a method according to claim 1.

According to the invention the method further comprises a hermetic sealing step in which the metallic structure of the conductors is hermetically sealed against gases, vapors, or liquids at room temperature. -During or after contacting the filaments of the end sections with each other, the surrounding metallic structure is treated in such a way that the interface area between the end sections is hermetically sealed. The hermetic sealing has the effect of making the metallic structure impermeable to the specified gases, vapors or liquids, i.e. the filaments are shielded from the environment such that on the one hand specified elements from the environment are prevented from getting into contact with the filaments and on the other hand molten material of the filaments is prevented from escaping from the filaments.

The inventive hermetic sealing allows joining processes and/or the synthesis step to be performed at overpressure, i.e. at least 2 bar (in particular > 20 bar which is mostly used for example in the reaction of Bi2212 to counteract the inner gas release during the Bi2212 synthesis, and / or to shrink the wire and improve the current density) without ambient material penetrating the wire. This increases the performance of the wire.

Furthermore, when using high temperature, in particular temperature > 90°C, during joining and/or during synthesis, liquid material from inner filaments can be prevented from escaping from the joining zone. As a result, the stoichiometry of the components can be maintained and a reduction in performance avoided.

The metallic structure surrounds the filaments and can be a metal sheath surrounding the multitude of filaments or an embedding metal matrix in which each filament is embedded.

Creating a cut surface means that cross-sections of the filaments are exposed, in particular oblique cross-sections, while the filaments stay surrounded or embedded by the metallic structure. The end sections are preferably wedge-shaped after the cut surfaces have been formed, i.e. the cut surfaces are preferably oblique to the extension of the filaments. The cut surface is preferably a straight surface but can also be stepped.

The connection zone is the area along the length of the wires within which the connection is made (overlap of the end sections and, if applicable, tubes).

The interface area is preferably created by bringing the cut surfaces into contact with each other such that the exposed filament cross-sections of the first end section face and are in proximity to the exposed filament cross-sections of a second end section and such that the cross section of the metallic structures of the end sections are adjacent to each other. In a preferred embodiment, the conductors comprises a multitude of filaments for producing a multifilament superconducting wire. When aligning the cut surfaces to each other, it is important to ensure that most filaments, preferably all filaments, abut each other. Due to the fact that the cross sections of the filaments are in contact with each other, the diameter of the filaments in the connection zone remains the same as outside the connection zone. This is the preferred solution, but not strictly mandatory since there can be some misalignment and / or deformation, especially because of the pressing and annealing processings.

The inventive hermetic sealing step is performed after creating the interface area.

In a preferred variant, the synthesis step is performed after the hermetic sealing step. In this case, the internal phase is safe against unfavorable condition in the synthesis (reaction phase), e.g. with regard to overpressure, or liquid leakage from inside. This variant applies in particular to precursor-wires comprising Bi2212 filaments, where the synthesis requires over pressure heat treatment. If over pressurized gas (in particular >20 bar) is not prevented from entering into the filaments, the reaction leads to a poor superconducting performance.

The temperature during the synthesis step is preferably higher than the temperature during the hermetic sealing step. This prevents the synthesis process from taking place during the hermetic sealing step. The fact that the hermetic sealing is at a lower temperature than the synthesis step permits to perform the hermetization prior to the synthesis reaction, avoiding eventual degradation in case the synthesis is performed in an environment of dangerous gases or pressurized gases or in general in environment which could cause the damage of the precursors and / or superconducting materials or in case there could be a leakage of material from inside the filaments.

The annealing temperature for synthesis to Nb3Sn is above ca. 550°C, to Bi2212 above ca. 860 °C, depending also on the gas environment (chemical composition, pressure).

In another variant, the synthesis step is performed during the hermetic sealing step. In this case, the hermetic sealing step can be carried out in a simpler way, e.g. by performing the hermetization and the synthesis during the same annealing process (e.g.: during a heating ramp).

The cut surfaces of the end sections are preferably pressed together, most preferably by using an additional pressing tool. The pressing tool is applied to the connection zone prior to the hermetic sealing step. Using an additional pressing tool allows to remove the pressing tool at any time needed.

Alternatively, for example with the ultrasonic welding, the ultrasonic weld can be used to press the two end sections between the anvil and the horn, and then the horn vibrate and performs the ultrasonic welding.

Another option is to put a metallic / metallic alloy block around the two end sections and then press the block such to deform it and keep the pressure and the shape at the joint. This could be used (and it could be more practical) whenever it is not necessary to remove the pressing tool, e.g. in case of Nb3Sn.

In a highly preferred variant, the pressing tool is removed from the connection zone prior to the synthesis process. Removing the pressing tool prior to the synthesis process is especial relevant for wires comprising Bi2212 with silver matrix in order to provide permeability to oxygen which is required for the synthesis process.

In special variant of the inventive method, the hermetic sealing step comprises **diffusion bonding** of the metallic structure of the end sections. Diffusion bonding is preferably performed prior synthesis. The joint (jointed end sections) are inserted into an furnace and annealed with a controlled composition atmosphere (if needed), at a temperature and time sufficient to induce the diffusion bonding (also known as diffusion welding) of the outer metal sheaths (metallic structure) and/or inner filaments sheaths (in particular of a metal /alloy similar to the outer sheath) of the two end sections but lower than a temperature that changes the superconducting properties of the material inside the wire (superconducting or precursor of superconducting materials). Instead of bonding the sheaths of the end sections directly, diffusion bonding can also be performed between the outer metal sheaths of the end sections and a tube placed around the metallic structure of the wire in the connection zone. The tube provides alignment, positioning and support for the two end sections, and also - if sufficiently massive - serves as an element which keep the end sections pressed together after an external pressure has been applied e.g. with a pressing tool. The tube is preferably made of the same material as the metallic structure, e.g. copper.

The diffusion bonding is preferably performed at 1 bar pressure of controlled atmosphere or vacuum.

It is preferred to apply a temperature below 800°C, in particular below 600°C, and preferentially between 100 and 500°C to the connection zone during performing the diffusion bonding. Thereby it is ensured that the hermetic sealing step does not affect the superconductivity-status of the precursor material or of the superconducting material in the wire endings. In particular, in case of a precursor, the filaments are not converted from precursor material into a superconducting material during the hermetic sealing step.

For the production of Bismuth superconductors, e.g. using Bi2212 (Bismuth strontium calcium copper oxide (Bi2Sr2CaCu2Ox) wire with precursor phases inside, diffusion bonding is preferably performed in an Oxygen atmosphere with in approximately 1 bar and a temperature below 800°C, in particular below 600°C, preferentially between 300 and 500°C.

For the production of Nb3Sn superconductors and NbTi superconductors, diffusion bonding for is preferably performed in a vacuum or in an inert atmosphere (Argon, Nitrogen, etc.) at approximately 1 bar and a temperature below 600°C, in particular between 200 and 500°C.

Alternatively, the hermetic sealing step may comprise **electroplating** a plating-material onto the wire in the connection zone. This involves creating a metal layer that surrounds the metallic structure of the electrical conductors in the connection area. Electroplating is preferably performed in a room atmosphere (i.e. at ambient pressure). The electroplated metal is preferably the same material as the metallic structure of the jointed conductors.

The plating material can be applied to the metallic structure of the wire or to a tube that surrounds the metallic structure of the wire in the connection zone. In the latter case, the plating-material is electroplated in the transition area of the tube to the metallic structure of the wire in order to seal the tube against the metallic structure. The tube provides alignment, positioning and support for the two end sections, and also - if sufficiently massive - serves as an element which keep the end sections pressed together after an external pressure has been applied e.g. with a pressing tool. The tube is preferably made of the same material as the metallic structure.

Electroplating is preferably used for wires having a metallic structure made of Copper. The plating-material preferably corresponds to the material of the metallic structure and/or the tube.

The plating-material electroplated in the connection zone is inter-diffused with the material of the metallic structure preferably by heating the connection zone after the plating process preferably above 200°C and preferably below 500°C.

In another alternative variant, the hermetic sealing step comprises **welding,** in particular ultrasonic welding. The ultrasonic welding process comprises the steps of pressing the endings together between a "horn" and an "anvil" of an ultrasonic welding tool and applying the ultrasonic vibration to the horn to weld during the pressing. Ultrasonic welding is preferably performed at ambient pressure.

In a further alternative variant, the hermetic sealing step comprises **glueing** using a glue based on charged particles.

The material on which the glue is based preferably corresponds to the material of the metallic structure of the wire, in particular silver or copper. During the glueing process the glue is only applied to the metallic structure, not to the filaments themselves, as the cross sections of the filaments must touch each other. The glueing connection is created outside the interface area complementary surface.

Preferably temperatures <200°C are applied during glueing.

Glueing is preferably performed at ambient pressure.

In order to maximize the superconducting performances of the joint, it is highly preferred that the end sections are aligned with maximal overlap.

In a preferred variant, the superconductor precursor material is Bi2212 or its components, wherein one of the specified gases is Argon and/or Helium and/or wherein one of the specified liquids is liquid Bi2212.

In this case, the material of the metallic structure is preferably silver.

Components of Bi2212 are Bismuth (Bi), Strontium (Sr), Calcium (Ca), Copper (Cu) and Oxygen (O). The precursor material of the Bi2212 is typically composed of mixture of oxides and complex oxides of Bi, Sr, Ca, Cu (Bi2212 itself comprised).

In another preferred variant, the superconductor precursor material is Nb3Sn or its precursor elements, wherein one of the specified gases is oxygen and/or helium and/or wherein one of the specified liquids is liquid Sn or its alloys.

In this case, the material of the metallic structure is preferably copper.

The synthesis step can be performed at overpressure. This is particularly relevant for filaments comprising Bi2212 and its precursors to improve and guarantee the performances (homogeneity and critical current values).

Alternatively, the synthesis step can be performed in vacuum (preferably <1 mbar, highly preferred <10-4 mbar) or normal pressure. This is particularly relevant for filaments comprising Nb3Sn and its precursors.

In a highly preferred variant, the metallic structure of the conductors is hermetically sealed towards at least one of argon, nitrogen, oxygen, helium gases below 100°C, and towards at least one of argon, nitrogen, helium gases above 100°C, and towards at least one of tin and bismuth liquids / vapors above their melting points and towards at least one of helium, nitrogen, superfluid helium liquids below the respective liquefaction temperatures.

In case of a wire comprising Bi2212, the metallic structure of the wire is hermetically sealed preferably towards argon, oxygen and helium gases below 100°C and towards argon and helium gases above 100°C and towards bismuth liquids / vapors above their melting points and towards helium, nitrogen and superfluid helium liquids below the respective liquefaction temperatures. In this case, the hermetization prevents the Ar in the Ar/oxygen mixture during the annealing up to 900°C in the over pressure furnace (Ar/O2 at e.g.: 25 bar) to enter into the Bi2212 filaments throughout the end openings and damaging / hindering the phase formation, and destroying the shrinking effect due to the external pressure towards the internal pressure in the filaments. At the same time, since the Bi2212 melts at approximately _860°C (generally in 1 bar oxygen partial pressure, but depending also on environmental and chemical parameters) and then recrystallize when cooled down, the hermetization avoids the liquid Bi2212 to escape from the filaments. Furthermore, when a magnet made of such a wire is immersed in liquid helium, the liquid helium should not penetrate inside the wire, otherwise, during a quench or heating (and the consequent helium transformation in gas), it can damage the wire integrity. On the other hand, a delicate point is that the oxygen gas can nevertheless (and it is also necessary to form the Bi2212 phase, which contains oxygen) pass through the silver sheath during synthesis step which is performed at higher temperatures, preferably at a temperature approximately > _850 °C (depending on the partial pressure of oxygen and chemical composition) (but not the argon or other gases / liquids).

In case of a wire comprising Nb3Sn, the metallic structure of the wire is hermetically sealed preferably towards oxygen, helium gases below 100°C, and towards oxygen, nitrogen, argon, water vapor and helium gases above 100°C, and towards tin liquids / vapors above their melting points and towards helium, nitrogen superfluid helium liquids below the respective liquefaction temperatures. In this case, the hermetization prevents the reaction of oxygen with the internal precursor materials: niobium, tin, copper in ambient atmosphere and during annealing (synthesis), thereby forming a gas tight joint. In addition, the joint is also liquid tight to prevent tin from escaping from the wire during melting (at 230°C) before it forms an intermediate phase. Furthermore, when the magnet is immersed in liquid helium, the helium is prevented from penetrating inside the wire. Otherwise, during a quench or heating (and the consequent helium transformation in gas), it can damage the wire integrity.

Further advantages of the invention are shown in the description and the drawing. Likewise, the above-mentioned features and those which are further described can be used according to the invention, either individually or in any combination. The embodiments shown and described are not to be understood as an exhaustive list, but rather have an exemplary character for the description of the invention.

### Detailed description of the invention and drawing

Fig. 1 shows a schematic diagram of the method according to the invention with the method steps in a chronological sequence.
Fig. 2a shows two wire end sections with cut surfaces.
Fig. 2b shows the two wire end sections aligned.
Fig. 2c shows the aligned end sections in a pressing tool.
Fig. 2d shows the aligned wire end sections in a furnace for diffusion welding.
Fig. 2e shows the final wire with joined and hermetically sealed end sections.
Fig. 3a shows the two wire end sections aligned and covered by an additional tube.
Fig. 3b shows the final wire with joined and hermetically sealed end sections with additional tube.

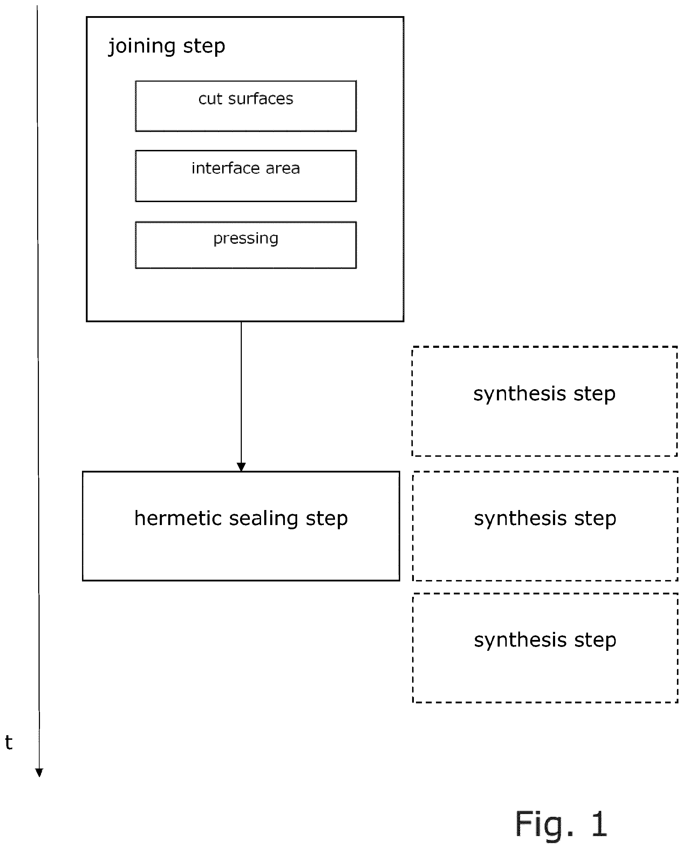

**Fig. 1** shows the essential method steps comprising a joining step, hermetic sealing step and synthesis step, wherein the synthesis step, in which the superconductor precursor material is turned into superconductor material, can be performed prior to, during or after the hermetic sealing step.

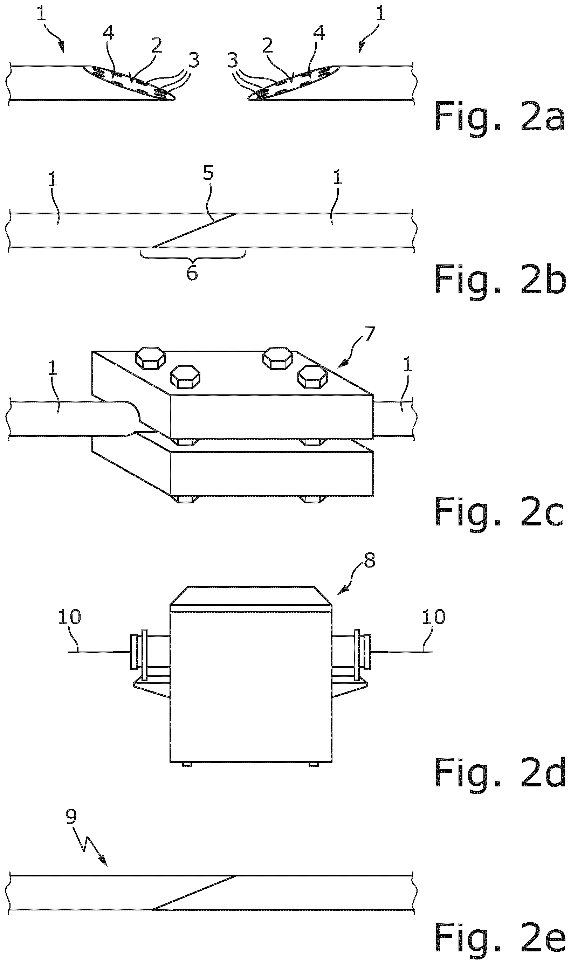

**Fig. 2a-2d** shows two end sections **1** of electrical conductors **10** comprising either a superconductor precursor material or a mixture of superconductor material and precursors of superconductor material during performing the inventive method.

**Fig. 2a** shows the wire end sections 1 with cut surfaces **2** which exposes filaments **3** in a metallic structure **4** (e.g. a matrix as shown in Fig. 1a). In the shown example, the cut surfaces 2 are straight and oriented oblique to the filaments elongation. This results in a wedge shape of the end sections 1. The cut surfaces 2 can be produced e.g. by grinding. The end sections 1 are complementary to each other, i.e. they complement each other so that they can be brought into a planar, in particular into a full-surface-contact with each other, as shown in **Fig. 2b****.** By bringing the cut surfaces 2 into a planar contact, an interface area **5** is created between the two end sections 1. The longitudinal extension of the aligned surfaces forms a connection zone **6.**

**Fig. 2c** shows a pressing tool **7** (e.g. two halve steel yokes which can be tightened with screws) which is used to press the aligned end sections 1 together in the area of the connection zone 6 in order to improve the contact of the cut surfaces 2. In this way, at least the metallic structures (preferably both, the metallic structure and the filaments) of the end sections 1 are brought into contact and the conductors 10 are joined to a longer wire. Although using the pressing tool 7 is preferred since it is an easy and practical way of performing the contacting between the metallic sheaths, pressing of the end sections 1 can also be performed by adding and pressing a massive material like a tube around and leave it, in case the further processing does not require its removal or it is compatible with the further processing.

In a first variant, the pressing tool remains applied during the diffusion welding annealing (hermetic sealing), then it is removed and the synthesis annealing step is performed without pressing tool. The first variant is preferably used for joining electrical conductors with filaments comprising Bi2122 or its precursors. By removing the pressing tool prior to the synthesis step, oxygen from the surrounding atmosphere is allowed to penetrate into the metal structure during the synthesis step. The synthesis step can be performed at higher temperature than the hermetic sealing.

In a second variant, the pressing tool remains applied during diffusion welding annealing (hermetic sealing) and the synthesis step, i.e. the synthesis step is performed without previously removing the pressing tool. The second variant is preferably used for joining electrical conductors with filaments comprising Nb3Sn or its precursors. The synthesis step can be performed at higher temperature than the hermetic sealing.

In a third variant, a single annealing process comprising the diffusion welding process (hermetic sealing), and the synthesis process without interruption of the annealing process is performed and the pressing tool remains applied during the whole annealing process. The second variant is preferably used for joining electrical conductors with filaments comprising Nb3Sn or its precursors. This last variant is preferable to the second one in case there is no need to operate on the joint or on the attached system at room temperature before the synthesis step.

To protect the interface area 5 against the penetration of gases from the surrounding atmosphere and against the escape of molten material from the filaments 3, the present invention provides for a hermetic sealing of the metallic structure 4.

There are several methods for realizing the hermetic sealing. **Fig. 2d** shows the aligned wire end sections in a furnace **8** for diffusion bonding, which is the most preferred method for performing hermetic sealing according to the invention. The aligned and pressed end sections 1 are inserted in the furnace 8 and annealed with a controlled composition atmosphere (if needed), at a temperature and within a time sufficient to induce the diffusion bonding (in a reasonable time) of the metallic structure 4. In case synthesis step should be performed after hermetic sealing, the sealing temperature must be lower than the temperature that changes the superconducting properties of the material inside the wire (superconducting or precursor of superconducting materials).

Other sealing methods are electroplating, welding or glueing. In other embodiments, the furnace 8 in Fig. 2d is then replaced by an electroplating machine, a welding machine, a pressing machine or ultrasonic welding machine respectively.

The pressing tool 7 is preferably removed after the aligned and hermetically sealed end sections 2 have been removed from the furnace 8. **Fig. 2d** shows a final wire **9** with joined and hermetically sealed end sections 1.

If the synthesis was not performed before or during hermetic sealing, the wire 9 is placed in a furnace with controlled atmosphere of prescribed gas composition and pressurized atmosphere (if necessary) and an additional annealing process is performed to change the superconducting properties of the material inside (synthesis step).

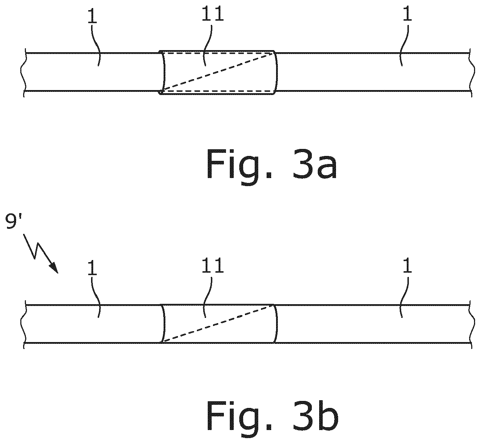

**Fig. 3a** shows aligned cut surfaces, which are surrounded by an additional tube **11** (preferably made of the same material as the metallic structure of the electrical conductors 10) in the connection zone 6. In this case, the hermetic sealing is performed between the tube 11 and the metallic structure 4.

**Fig. 3b** shows the final wire **9'** with joined and hermetically sealed end sections 1 with additional tube 11.

The usage of an additional tube 11 is in particular advantageous when using electroplati ng.

### List of reference signs

- 1: end sections
- 2: cut surfaces
- 3: filaments
- 4: metallic structure (matrix, sheath)
- 5: interface area
- 6: connection zone
- 7: pressing tool
- 8: furnace
- 9: hermetically sealed superconducting wire without tube
- 9': hermetically sealed superconducting wire with tube
- 10: electrical conductors
- 11: tube surrounding the end sections in the connection zone

### Literature list

US 5244876 A
US 5949131 A
US 5051397 A
US 5111574 A
EP 0545608 A2
EP 0556837 A2
US 9966167 B1

## Claims

1. A method for producing a superconductive joint from a number of electrical conductors (10), each electrical conductor (10) having one or a multitude of filaments (3) comprising either a superconductor precursor material or a mixture of superconductor material and precursors of superconductor material, encapsulated in a metallic structure (4),
the method comprising:
• a joining step, for joining end sections (1) of the electrical conductors (10), the joining step comprising:
∘ generating two complementary cut surfaces (2) on the end sections (1) thereby exposing cross sections of the filaments (3);
∘ forming an interface area (5) of the cut surfaces (2) by aligning the two end sections (1) in a connection zone (6) such that the cut surfaces (2) of the end sections (1) face each other and the exposed filament cross sections abut each other;
∘ pressing the aligned complementary cut surfaces (2) together;
• a synthesis step, in which superconductor precursor material is converted into superconductor material by annealing,
**characterized in that** the method further comprises
• a hermetic sealing step in which the metallic structure of the conductors (10) is hermetically sealed against gases, vapors, or liquids at room temperature.

2. Method according to claim 1, **characterized in that** the synthesis step is performed after the hermetic sealing step.

3. Method according any one of the preceding claims, **characterized in that** the temperature during the synthesis step is higher than the temperature during the hermetic sealing step.

4. Method according to claim 1, **characterized in that** the synthesis step is performed during the hermetic sealing step.

5. Method according to any of the preceding claims, **characterized in that** the cut surfaces (2) of the end sections (1) are pressed together using a pressing tool (7).

6. Method according to claim 5, **characterized in that** the pressing tool (7) is removed from the connection zone (6) prior to the synthesis process.

7. Method according to any of the claims 1 to 6, **characterized in that** the hermetic sealing step comprises diffusion bonding of the metallic structure (4) of the end sections.

8. Method according to claim 7, **characterized in that** the diffusion bonding is performed at 1 bar pressure of controlled atmosphere or vacuum.

9. Method according to claim 7 or 8, **characterized in that** a temperature below 800°C, in particular below 600°C, and preferentially between 100 and 500°C is applied to the connection zone (6) during performing the diffusion bonding.

10. Method according to any of the claims 1 to 6, **characterized in that** the hermetic sealing step comprises electroplating a plating-material onto the wire in the connection zone (6).

11. Method according to claim 10, **characterized in that** the plating-material electroplated in the connection zone (6) is inter-diffused with the material of the metallic structure (4) by heating the connection zone after the plating process preferably above 200°C and preferably below 500°C.

12. Method according to any of the claims 1 to 6, **characterized in that** the hermetic sealing step comprises welding, in particular ultrasonic welding.

13. Method according to any of the claims 1 to 6, **characterized in that** the hermetic sealing step comprises glueing using a glue based on charged particles.

14. Method according to any of the preceding claims, **characterized in that** the end sections are aligned with maximal overlap.

15. Method according to any of the claims 1 to 14, **characterized in that** the superconductor precursor material is Bi2212 or its components, wherein one of the specified gases is Argon and/or Helium and/or wherein one of the specified liquids is liquid Bi2212.

16. Method according to any of the claims 1 to 14, **characterized in that** the superconductor precursor material is Nb3Sn or its precursor elements, wherein one of the specified gases is oxygen and/or helium and/or wherein one of the specified liquid is liquid Sn or its alloys.

17. Method according to any one of claims 1 to 16, **characterized in that** the synthesis step is performed at overpressure

18. Method according to any one of claims 1 to 16, **characterized in that** synthesis is performed in vacuum or normal pressure

19. Method according to any of the claims 1 to 17, **characterized in that** the metallic structure (4) of the conductors (10) is hermetically sealed towards
• at least one of argon, nitrogen, oxygen, helium gases preferably below 100°C, and
• at least one of argon, nitrogen, helium gases preferably above 100°C, and
• at least one of tin and bismuth liquids / vapors above their melting points and
• at least one of helium, nitrogen, superfluid helium liquids below the respective liquefaction temperatures.

## Amended claims

### Amended claims in accordance with Rule 137(2) EPC.

1. A method for producing a superconductive joint from a number of electrical conductors (10), each electrical conductor (10) having one or a multitude of filaments (3) comprising either a superconductor precursor material or a mixture of superconductor material and precursors of superconductor material, encapsulated in a metallic structure (4),
the method comprising:
• a joining step, for joining end sections (1) of the electrical conductors (10), the joining step comprising:
∘ generating two complementary cut surfaces (2) on the end sections (1) thereby exposing cross sections of the filaments (3);
∘ forming an interface area (5) of the cut surfaces (2) by aligning the two end sections (1) in a connection zone (6) such that the cut surfaces (2) of the end sections (1) face each other and the exposed filament cross sections abut each other;
∘ pressing the aligned complementary cut surfaces (2) together;
• a synthesis step, in which superconductor precursor material is converted into superconductor material by annealing, and
• a hermetic sealing step in which the metallic structure of the conductors (10) is hermetically sealed against gases, vapors, or liquids at room temperature,
**characterized in that** the synthesis step is performed after the hermetic sealing step.

2. Method according to claim 1, **characterized in that** the temperature during the synthesis step is higher than the temperature during the hermetic sealing step.

3. Method according to any of the preceding claims, **characterized in that** the cut surfaces (2) of the end sections (1) are pressed together using a pressing tool (7).

4. Method according to claim 3, **characterized in that** the pressing tool (7) is removed from the connection zone (6) prior to the synthesis process.

5. Method according to any of the claims 1 to 4, **characterized in that** the hermetic sealing step comprises diffusion bonding of the metallic structure (4) of the end sections.

6. Method according to claim 5, **characterized in that** the diffusion bonding is performed at 1 bar pressure of controlled atmosphere or vacuum.

7. Method according to claim 5 or 6, **characterized in that** a temperature below 800°C, in particular below 600°C, and preferentially between 100 and 500°C is applied to the connection zone (6) during performing the diffusion bonding.

8. Method according to any of the claims 1 to 4, **characterized in that** the hermetic sealing step comprises electroplating a plating-material onto the wire in the connection zone (6).

9. Method according to claim 8, **characterized in that** the plating-material electroplated in the connection zone (6) is inter-diffused with the material of the metallic structure (4) by heating the connection zone after the plating process preferably above 200°C and preferably below 500°C.

10. Method according to any of the claims 1 to 4, **characterized in that** the hermetic sealing step comprises welding, in particular ultrasonic welding.

11. Method according to any of the claims 1 to 4, **characterized in that** the hermetic sealing step comprises glueing using a glue based on charged particles.

12. Method according to any of the preceding claims, **characterized in that** the end sections are aligned with maximal overlap.

13. Method according to any of the claims 1 to 12, **characterized in that** the superconductor precursor material is Bi2212 or its components, wherein one of the specified gases is Argon and/or Helium and/or wherein one of the specified liquids is liquid Bi2212.

14. Method according to any of the claims 1 to 12, **characterized in that** the superconductor precursor material is Nb3Sn or its precursor elements, wherein one of the specified gases is oxygen and/or helium and/or wherein one of the specified liquid is liquid Sn or its alloys.

15. Method according to any one of claims 1 to 14, **characterized in that** the synthesis step is performed at overpressure

16. Method according to any one of claims 1 to 14, **characterized in that** synthesis is performed in vacuum or normal pressure

17. Method according to any of the claims 1 to 15, **characterized in that** the metallic structure (4) of the conductors (10) is hermetically sealed towards
• at least one of argon, nitrogen, oxygen, helium gases preferably below 100°C, and
• at least one of argon, nitrogen, helium gases preferably above 100°C, and
• at least one of tin and bismuth liquids / vapors above their melting points and
• at least one of helium, nitrogen, superfluid helium liquids below the respective liquefaction temperatures.

## Amended claims

### Amended claims in accordance with Rule 137(2) EPC.

1. A method for producing a superconductive joint from a number of electrical conductors (10), each electrical conductor (10) having one or a multitude of filaments (3) comprising either a superconductor precursor material or a mixture of superconductor material and precursors of superconductor material, encapsulated in a metallic structure (4),
the method comprising:
• a joining step, for joining end sections (1) of the electrical conductors (10), the joining step comprising:
∘ generating two complementary cut surfaces (2) on the end sections (1) thereby exposing cross sections of the filaments (3);
∘ forming an interface area (5) of the cut surfaces (2) by aligning the two end sections (1) in a connection zone (6) such that the cut surfaces (2) of the end sections (1) face each other and the exposed filament cross sections abut each other;
∘ pressing the aligned complementary cut surfaces (2) together;
• a synthesis step, in which superconductor precursor material is converted into superconductor material by annealing, and
• a hermetic sealing step in which the metallic structure of the conductors (10) is hermetically sealed against gases, vapors, or liquids at room temperature,
**characterized in that** the synthesis step is performed after the hermetic sealing step.

2. Method according to claim 1, **characterized in that** the temperature during the synthesis step is higher than the temperature during the hermetic sealing step.

3. Method according to any of the preceding claims, **characterized in that** the cut surfaces (2) of the end sections (1) are pressed together using a pressing tool (7).

4. Method according to claim 3, **characterized in that** the pressing tool (7) is removed from the connection zone (6) prior to the synthesis process.

5. Method according to any of the claims 1 to 4, **characterized in that** the hermetic sealing step comprises diffusion bonding of the metallic structure (4) of the end sections.

6. Method according to claim 5, **characterized in that** the diffusion bonding is performed at 1 bar pressure of controlled atmosphere or vacuum.

7. Method according to claim 5 or 6, **characterized in that** a temperature below 800°C, in particular below 600°C, and preferentially between 100 and 500°C is applied to the connection zone (6) during performing the diffusion bonding.

8. Method according to any of the claims 1 to 4, **characterized in that** the hermetic sealing step comprises electroplating a plating-material onto the wire in the connection zone (6).

9. Method according to claim 8, **characterized in that** the plating-material electroplated in the connection zone (6) is inter-diffused with the material of the metallic structure (4) by heating the connection zone after the plating process preferably above 200°C and preferably below 500°C.

10. Method according to any of the claims 1 to 4, **characterized in that** the hermetic sealing step comprises welding, in particular ultrasonic welding.

11. Method according to any of the claims 1 to 4, **characterized in that** the hermetic sealing step comprises glueing using a glue based on charged particles.

12. Method according to any of the preceding claims, **characterized in that** the end sections are aligned with maximal overlap.

13. Method according to any of the claims 1 to 12, **characterized in that** the superconductor precursor material is Bi2212 or its components, wherein one of the specified gases is Argon and/or Helium and/or wherein one of the specified liquids is liquid Bi2212.

14. Method according to any of the claims 1 to 12, **characterized in that** the superconductor precursor material is Nb3Sn or its precursor elements, wherein one of the specified gases is oxygen and/or helium and/or wherein one of the specified liquid is liquid Sn or its alloys.

15. Method according to any one of claims 1 to 14, **characterized in that** the synthesis step is performed at overpressure

16. Method according to any one of claims 1 to 14, **characterized in that** synthesis is performed in vacuum or normal pressure

17. Method according to any of the claims 1 to 15, **characterized in that** the metallic structure (4) of the conductors (10) is hermetically sealed towards
• at least one of argon, nitrogen, oxygen, helium gases preferably below 100°C, and
• at least one of argon, nitrogen, helium gases preferably above 100°C, and
• at least one of tin and bismuth liquids / vapors above their melting points and
• at least one of helium, nitrogen, superfluid helium liquids below the respective liquefaction temperatures.
